Europäisches Patentamt

European Patent Office

Office européen des brevets

(19)

(11) Publication number: **0 045 561**
**B1**

(12) # EUROPEAN PATENT SPECIFICATION

(45) Date of publication of patent specification: **11.03.87**

(51) Int. Cl.⁴: **H 01 L 23/54,** H 01 L 23/28

(21) Application number: **81302676.2**

(22) Date of filing: **16.06.81**

(54) Semiconductor device comprising memory circuits.

(30) Priority: **17.06.80 JP 81953/80**

(43) Date of publication of application:
**10.02.82 Bulletin 82/06**

(45) Publication of the grant of the patent:
**11.03.87 Bulletin 87/11**

(84) Designated Contracting States:
**DE FR GB**

(56) References cited:
**US-A-4 494 217**

**IBM TECHNICAL DISCLOSURE BULLETIN, vol. 22, no. 4, September 1979, pages 1460-1461, New York (USA); J.A. BRODY et al: "Storage and logic errors in dy namic memory devices due to innate radio-active materials in packaging and wafer"**

**Abstracts of Japanese Patents 56-94650, 55-140249, 58-77230, 58-48950, 58-43546**

(73) Proprietor: **FUJITSU LIMITED**
**1015, Kamikodanaka Nakahara-ku**
**Kawasaki-shi Kanagawa 211 (JP)**

(72) Inventor: **Miyasaka, Kiyoshi**
**577-45, Iijima-cho Totsuka-ku**
**Yokohama-shi Kanagawa 244 (JP)**

(74) Representative: **Sunderland, James Harry et al**
**HASELTINE LAKE & CO Hazlitt House 28**
**Southampton Buildings Chancery Lane**
**London WC2A 1AT (GB)**

## Description

### Field of the Invention

This invention relates to a semiconductor device, particularly a semiconductor device comprising memory circuits coated with a protective resinous film in order to eliminate soft errors by shielding radioactive rays.

### The Prior Art

A semiconductor device, on which memory cells etc. are fabricated, is usually enclosed within a ceramic or plastic package. It is known that the ceramic materials are contaminated with uranium and thorium in an amount of several parts per million and the plastic package materials include ceramic fillers which are also contaminated with radioactive materials.

The radioactive materials emit radioactive rays. Such irradiation, particularly α-particles, induces pairs of electrons and holes in the substrate and is apt to change the potential of the storage capacitor and circuit-nodes and, consequently, this change causes erroneous operation of memory circuits which is usually called soft errors, particularly in the case of dynamic random access memories.

In order to eliminate such erroneous operation of memory circuits, a protective film made of a radiation shielding resin, such as polyimide and silicone, is generally applied on the surface of a semiconductor chip. When the energy of the emitting α-particle is assumed to be 5 MeV, the resinous film must have a thickness of from 30 to 50 μm in order to inhibit the penetration of α-particles. This protective film is thicker than other films applied on a semiconductor device, such as silicon oxide film, phospho-silicate glass and so on.

The resinous material suffers from a large strain due to the contraction of its volume when it is cured on the substrate. Furthermore, the difference of thermal expansion between the protective resinous material and the substrate material, e.g., polyimide and silicon, affects mechanical strain, especially when the chip is enclosed in a ceramic package at a temperature of about 450°C. Because the coefficients of thermal expansion of polyimide, silicone and silicon are $27 \times 10^{-6}$/°C, $50 \times 10^{-6}$/°C and $2.3 \times 10^{-6}$/°C, respectively, the expansion of the coating resin is ten times larger than that of the substrate. This strain is emphasized by the thickness and coating area of the protective film.

Japanese Patent Application Laid-open No. 55-128851 of J. Shirasu et al. discloses a semiconductor device prepared from a silicon wafer which is coated by a protective resinous film except for the bonding pads region and the scribing region. However, this patent application does not teach to divide the protective resinous film into several portions so as to decrease the area of a single coating portion and, consequently, reduce the amount of the strain caused between the protective film and the substrate.

### Disclosure of the Invention

It is an object of the present invention to eliminate soft errors of a semiconductor device due to the irradiation of a radioactive ray.

It is another object of the present invention to reduce mechanical strain which may be caused between the protective film and the substrate in a semiconductor device.

Other objects and advantages of the present invention will further become apparent from the following description.

According to the present invention, there is provided a semiconductor device comprising a chip of a semiconductor substrate in which memory circuits including memory cells and sense amplifiers are fabricated, with a resinous film formed on said chip for shielding radioactive rays, characterised in that the resinous film is divided into a plurality of portions, said portions being separated from one another and coating at least said memory cells and sense amplifiers.

It is convenient that elements which have high resistivity against irradiation of radioactive rays, such as decoders and clock generators, are fabricated in the areas by which said portions of said resinous film are separated from one another. It is advisable that said resinous film is not applied on bonding pads. Convenient that said resinous film is applied only on said memory cells and said sense amplifiers.

As another aspect of the present invention, there is provided a semiconductor device comprising a chip of semiconductor substrate in which memory cells and sense amplifiers are fabricated, with a resinous film formed on said chip for shielding radioactive rays and coating at least said memory cells and sense amplifiers, characterised in that a part of said resinous film is removed at the portions where elements such as decoders but other than said memory cells and sense amplifiers, are formed, such that the strain between said resinous film and substrate becomes small.

It is preferable that said resinous film is made of polyimide or silicone.

### Brief Description of the Drawings

Fig. 1 shows the plan of an embodiment of the semiconductor device of the present invention.

Fig. 2 shows the plan of another embodiment of the semiconductor device of the present invention.

Fig. 3 shows the plan of another embodiment of the semiconductor device of the present invention.

### Best Mode for Carrying Out the Invention

The present invention will be described in detail referring to the drawings.

In a semiconductor device 1, the areas of memory cells 2 or sense amplifiers 3 are covered by individual portions of the protective resinous film (shown as hatched portions) which are separated from one another by the areas where decoders 4 are fabricated. Therefore, each portion of the resinous film which covers the region 2 or 3 has relatively small area. And the resinous film does not cover the areas where decoders 4 and peripheral circuits, such as clock generators and I/O buffers 5 and pads 6 are fabricated.

These portions of the resinous film may be easily formed by a usual method, such as masked screen printing and photolithography followed by etching using hydrazine $N_2H_4$.

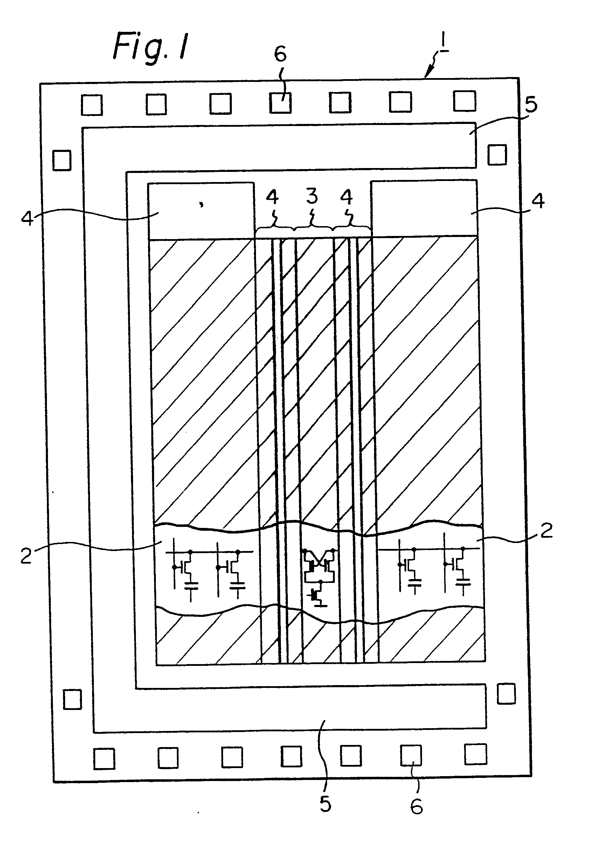

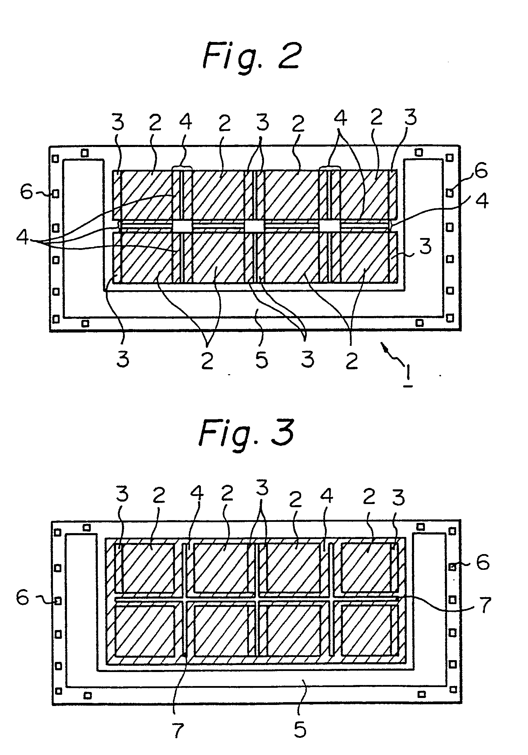

The chip sizes of the semiconductor devices, for example, shown in Figs. 1 and 2 are 5.3 mm × 2.8 mm and 6.5 mm × 3.4 mm, respectively. However, the sizes of individual portions of the resinous films are as small as 3.9 mm × 0.8 mm and 1.2 mm × 1.2 mm, respectively. Although the thickness of the resinous film is relatively large as 50 μm, the contraction by curing and the thermal expansion of the coating resin cause relatively small strain between the coating resinous film and the substrate and, consequently, the reliability of the semiconductor device is improved.

In Fig. 3, the resinous film (shown as hatched portion) is not divided into a plurality of portions. But a part of the resinous film is removed at the portion 7 where circuits, such as decoders 4, other than memory cells 2 and sense amplifiers 3 are fabricated. In this embodiment, a strain between the resinous film and substrate becomes small.

Of course, the semiconductor devices according to the present invention can inhibit the penetration of radioactive ray to irradiation sensitive members, such as memory cells and sense amplifiers, so that they do not suffer from the so-called soft errors during its operation.

### Claims

1. A semiconductor device comprising a chip of a semiconductor substrate in which memory circuits including memory cells and sense amplifiers are fabricated, with a resinous film formed on said chip for shielding radioactive rays, characterised in that the resinous film is divided into a plurality of portions, said portions being separated from one another and coating at least said memory cells and said sense amplifiers.

2. A semiconductor device according to claim 1, characterised in that elements which have high resistivity against irradiation of radioactive rays, such as decoders, clock generators and I/O buffers, are fabricated in the areas by which said portions of said resinous film are separated from one another.

3. A semiconductor device according to claim 1, characterised in that said resinous film is not applied on bonding pads.

4. A semiconductor device according to claim 1, characterised in that said resinous film is applied only on said memory cells and said sense-amplifiers.

5. A semiconductor device according to any one of the preceding claims, characterised in that said resinous film is made of polyimide or silicone.

6. A semiconductor device comprising a chip of a semiconductor substrate in which memory cells and sense amplifiers are fabricated, with a resinous film formed on said chip for shielding radioactive rays and coating at least said memory cells and sense amplifiers, characterised in that a part of said resinous film is removed at the portions where elements such as decoders but other than said memory cells and sense amplifiers are formed, such that the strain between said resinous film and substrate becomes small.

7. A semiconductor device according to claim 6, characterised in that said resinous film is made of polyimide or silicone.

### Patentansprüche

1. Halbleitervorrichtung mit einem Chip auf einem Halbleitersubstrat, in dem Speicherschaltungen mit Speicherzellen und Leseverstärkern hergestellt sind, mit einem harzartigen Film, der auf dem genannten Chip gebildet ist, um radioaktive Strahlen abzuschirmen, dadurch gekennzeichnet, daß der harzartige Film in eine Vielzahl von Abschnitten unterteilt ist, welche Abschnitte voneinander getrennt sind und wenigstens die genannten Speicherzellen und die genannten Leseverstärker bedecken.

2. Halbleitervorrichtung nach Anspruch 1, dadurch gekennzeichnet, daß die Elemente, die eine hohe Widerstandsfähigkeit gegen Einfall von radioaktiven Strahlen haben, wie Decoder, taktgeneratoren und I/O-Puffer in den Bereichen hergestellt sind, durch welche die genannten Abschnitte des harzartigen Films voneinander getrennt sind.

3. Halbleitervorrichtung nach Anspruch 1, dadurch gekennzeichnet, daß der harzartige Film nicht auf Verbindungsflächen aufgebracht ist.

4. Halbleitervorrichtung nach Anspruch 1, dadurch gekennzeichnet, daß der harzartige Film nur auf den genannten Speicherzellen und den Lesverstärkern aufgebracht ist.

5. Halbleitervorrichtung nach einem der vorhergehenden Ansprüche, dadurch gekennzeichnet, daß der genannte harzartige Film aus Polyimid oder Silicon besteht.

6. Halbleitervorrichtung mit einem Chip aus Halbleitersubstrat, in dem Speicherzellen und Leseverstärker hergestellt sind, mit einem harzartigen Film, der auf dem genannten Chip zur Abschirmung radioaktiver Strahlen gebildet ist und wenigstens die genannten Speicherzellen und Leseverstärker bedeckt, dadurch gekennzeichnet, daß ein Teil des genannten harzartigen Films bei denjenigen Abschnitten entfernt ist, wo Elemente wie Decoder, jedoch andere als die genannten Speicherzellen und Leseverstärker gebildet sind, so daß die Spannung zwischen dem harzartigen Film und dem Substrat klein wird.

7. Halbleitervorrichtung nach Anspruch 6, dadurch gekennzeichnet, daß der harzartige Film aus Polyimid oder Silicon besteht.

**Revendications**

1. Dispositif à semi-conducteur comportant une pastille d'un substrat semi-conducteur dans lequel sont formés des circuits de mémoire comprenant des cellules de mémoire et des amplificateurs de lecture, avec une pellicule résineuse formée sur ladite pastille pour arrèter des rayons radioactifs, caractérisé en ce que la pellicule résineuse est divisée en plusieurs parties, lesdites parties étant séparées les unes des autres et recouvrant au moins lesdites cellules de mémoire et lesdits amplificateurs de lecture.

2. Dispositif à semi-conducteur selon la revendication 1, caractérisé en ce que des éléments qui ont une haute résistance contre l'irradiation par des rayons radioactifs, comme des décodeurs, des générateurs d'horloge et des tampons d'entrée/sortie sont fabriqués dans des régions par lesquelles lesdites parties de la pellicule résineuse sont séparées les unes des autres.

3. Dispositif à semi-conducteur selon la revendication 1, caractérisé en ce que ladite pellicule résineuse n'est pas appliquée sur les surfaces de connexion.

4. Dispositif à semi-conducteur selon la revendication 1, caractérisé en ce que ladite pellicule résineuse n'est appliquée que sur lesdites cellules de mémoire et lesdits amplificateurs de lecture.

5. Dispositif à semi-conducteur selon l'une quelconque des revendications précédentes, caractérisé en ce que ladite pellicule résineuse est faite de polyimide ou de silicone.

6. Dispositif à semi-conducteur comportant une pastille de substrat semi-conducteur dans lequel sont fabriquées des cellules de mémoire et des amplificateurs de lecture, avec une pellicule résineuse formée sur ladite pastille pour arrèter des rayons radioactifs et recouvrant au moins lesdites cellules de mémoire et les amplificateur de lecture, caractérisé en ce qu'une partie de la pellicule résineuse est enlevée dans des parties ou sont formés des éléments tels que des décodeurs mais autres que lesdites cellules de mémoire et lesdits amplificateurs de lecture, de manière que les contraintes entre ladite pellicule résineuse et le substrat soient faibles.

7. Dispositif à semi-conducteur selon la revendication 6, caractérisé en ce que ladite pellicule résineuse est faite de faite de polyimide ou de silicone.

# Fig. 1

# Fig. 2

# Fig. 3